# EUROPEAN PATENT APPLICATION

(11) **EP 4 823 307 A2**
(43) Date of publication of application: **14.10.2026**
(21) Application number: 26159459.2
(22) Date of filing: 19.02.2026
(51) Int. Cl.: H10P 72/70, H10W 74/01, H10W 74/10, H10W 90/20, H10W 90/28, H10W 90/00

(54) **METHOD OF FORMING A SEMICONDUCTOR PACKAGE INCLUDING SEMICONDUCTOR CHIPS AND RELATED SEMICONDUCTOR PACKAGE**

(30) Priority: 10.04.2025 KR 20250046607
(71) Applicant: SK hynix Inc., Bubal-eub Icheon-si Gyeonggi-do 17336 (KR)
(72) Inventor: PARK, Ji Ho, 17336 Icheon-si, Gyeonggi-do (KR)
(74) Representative: Isarpatent

(57) **Abstract**

The present invention is directed to a semiconductor package comprising:
a base chip having a groove formed at an edge;
a residual adhesive layer in the groove;
a core chip on the base chip;
a top chip on the core chip; and
an encapsulation layer disposed between the base chip and the top chip, covering the core chip and the residual adhesive layer, and filling the groove.

## Description

### BACKGROUND

### 1. Technical Field

The present disclosure relates to a method of forming a semiconductor package having semiconductor chips and a semiconductor package.

### 2. Related Art

In response to multifunctionality and high integration of semiconductor packages, techniques for vertically stacking a plurality of semiconductor chips have been explored.

The stacked semiconductor chips may include through-electrodes. The semiconductor chips may be connected to each other using bump or hybrid bonding technology.

A semiconductor package may include a plurality of core chips stacked on a base chip and an encapsulation layer. The encapsulation layer may surround side surfaces of the base chip and the plurality of core chips.

### SUMMARY

A method of forming a semiconductor package according to an embodiment of the present disclosure may include forming a carrier chip including a base chip, a silicon layer, and an adhesive layer between the base chip and the silicon layer. A core chip may be stacked on a wafer including a top chip. The carrier chip may be stacked on the core chip. An encapsulation layer may be formed on the wafer to cover the core chip and the carrier chip. The silicon layer and the adhesive layer may be removed. The encapsulation layer and the wafer may be diced.

A method of forming a semiconductor package according to an embodiment of the present disclosure may include forming a carrier chip including a base chip, a silicon layer, and an adhesive layer between the base chip and the silicon layer. A core chip may be stacked on a top chip. The carrier chip may be stacked on the core chip. An encapsulation layer may be formed that covers the top chip, the core chip, and the carrier chip. The silicon layer and the adhesive layer may be removed. The encapsulation layer may be diced.

A method of forming a semiconductor package according to an embodiment of the present disclosure may include forming an adhesive layer between a base chip and a silicon layer. A core chip may be stacked on the base chip. A top chip may be stacked on the core chip. An encapsulation layer may be formed to cover the top chip, the core chip, and the base chip. The silicon layer and the adhesive layer may be removed. The encapsulation layer may be diced.

A semiconductor package according to an embodiment of the present disclosure may include a base chip having a groove formed at an edge. A residual adhesive layer may be disposed in the groove. A core chip may be disposed on the base chip. A top chip may be disposed on the core chip. An encapsulation layer may be provided between the base chip and the top chip, covering the core chip and the residual adhesive layer and filling the groove.

A semiconductor package according to an embodiment of the present disclosure may include a base chip having a groove formed at an edge. A core chip may be disposed on the base chip. A top chip may be disposed on the core chip. An encapsulation layer may be provided between the base chip and the top chip and cover the core chip. A residual adhesive layer and a residual encapsulation layer may be disposed in the groove.

### BRIEF DESCRIPTION OF THE DRAWINGS

FIG. 1 is a cross-sectional view of a semiconductor package according to an embodiment of the present disclosure.
FIG. 2 is an enlarged view of an area of FIG. 1.
FIG. 3 to FIG. 6 are enlarged views illustrating semiconductor packages according to an embodiment of the present disclosure.
FIG. 7 is a cross-sectional view of a semiconductor package according to an embodiment of the present disclosure.
FIG. 8 is an enlarged view of an area of FIG. 7.
FIG. 9 and FIG. 10 are cross-sectional views illustrating semiconductor packages according to an embodiment of the present disclosure.
FIG. 11 is a flowchart illustrating a method of forming a semiconductor package according to an embodiment of the present disclosure.
FIG. 12 to FIG. 31 are cross-sectional views of a semiconductor package formed utilizing a method of forming a semiconductor package according to an embodiment of the present disclosure.
FIG. 32 is a flowchart illustrating a method of forming a semiconductor package according to an embodiment of the present disclosure.
FIG. 33 to FIG. 36 are cross-sectional views of a semiconductor package formed utilizing a method of forming a semiconductor package according to an embodiment of the present disclosure.
FIG. 37 is a flowchart illustrating a method of forming a semiconductor package according to an embodiment of the present disclosure.
FIG. 38 to FIG. 40 are cross-sectional views of a semiconductor package formed utilizing a method of forming a semiconductor package according to an embodiment of the present disclosure.
FIG. 41 is a flowchart illustrating a method of forming a semiconductor package according to an embodiment of the present disclosure.
FIG. 42 to FIG. 44 are cross-sectional views of a semiconductor package formed utilizing a method of forming a semiconductor package according to an embodiment of the present disclosure.

### DETAILED DESCRIPTION

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

The cross-hatching throughout the figures illustrates corresponding or similar areas between the figures rather than indicating the materials associated with the areas.

When one element is identified as "connected" to another element, the elements may be connected directly or through an intervening element between the elements. When two elements are identified as "directly connected," one element is directly connected to the other element without an intervening element between the two elements.

When one element is identified as "on," "over," or "under," another element, the elements may directly contact each other or an intervening element may be disposed between the elements.

Terms such as "vertical," "horizontal," "top," "below," "under," "over," "on," "side," "upper," "lower," "higher," "front," "rear," "column," "row," "level," and other terms implying relative spatial relationship or orientation are utilized only for the purpose of ease of description or reference to a drawing and are not otherwise limiting. Other spatial relationships or orientations not shown in the drawings or described in the specification are possible within the scope of the present disclosure.

Terms such as "first" and "second" are used to distinguish between various elements and do not imply size, order, priority, quantity, or importance of the elements. For example, a first element may be named as a second element in one example, and the second element may be named as a first element in another example.

In the description, when an element included in an embodiment is described in singular form, the element may be interpreted to include a plurality of elements performing the same or similar functions.

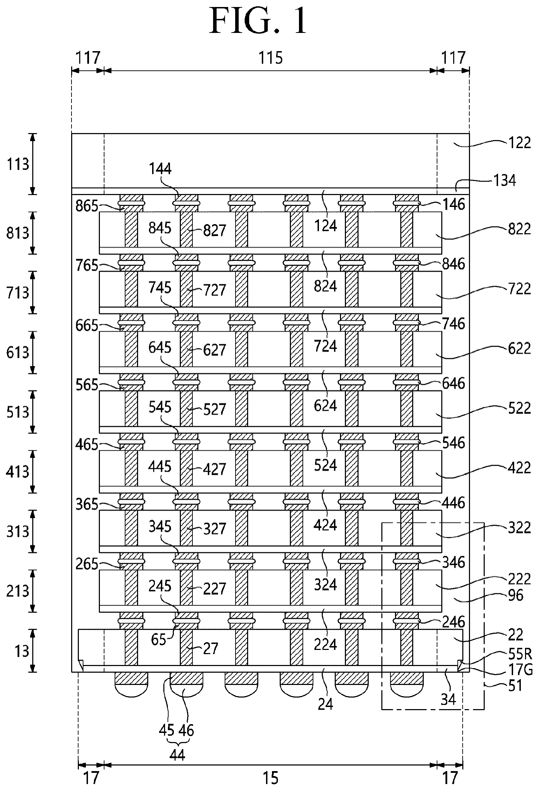

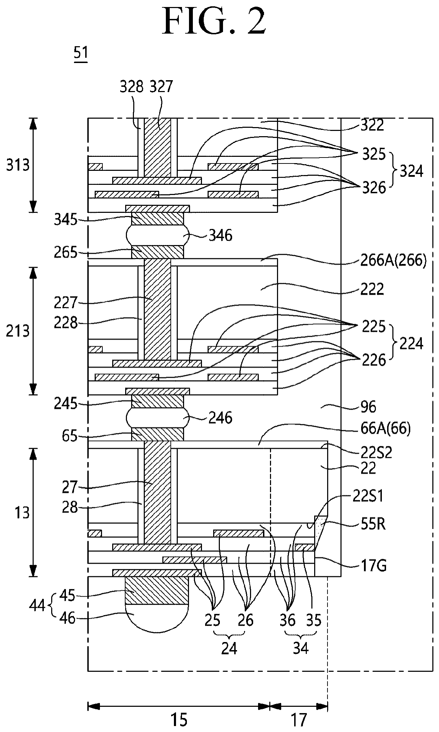

FIG. 1 is a cross-sectional view of a semiconductor package according to an embodiment of the present disclosure. FIG. 2 is an enlarged view of area 51 of FIG. 1.

Referring to FIG. 1, a semiconductor package according to an embodiment of the present disclosure includes a base chip 13, a residual adhesive layer 55R, an encapsulation layer 96, a top chip 113, and a plurality of core chips 213, 313, 413, 513, 613, 713, and 813. The plurality of core chips may include a first core chip 213, a second core chip 313, a third core chip 413, a fourth core chip 513, a fifth core chip 613, a sixth core chip 713, and a seventh core chip 813.

The base chip 13 includes a base substrate 22, a base circuit 24, a base through-electrode 27, and a base auxiliary structure 34. The base chip 13 includes a first active region 15 and a first peripheral region 17. The first peripheral region 17 may be continuous with a side of the first active region 15.

The base circuit 24 is disposed under a lower surface of the base substrate 22 in the first active region 15. The base through-electrode 27 passes through the base substrate 22 in a vertical direction. The base auxiliary structure 34 is disposed under a lower surface of the base substrate 22 in the first peripheral region 17. The base auxiliary structure 34 may be continuous with a side of the base circuit 24. A groove 17G is formed at an edge of the base chip 13. The groove 17G is disposed at a side of the base chip 13 and at a lower surface of the base chip 13. The residual adhesive layer 55R is disposed in the groove 17G. A base front electrode 44 is disposed under the lower surface of the base chip 13. In an embodiment, the base front electrode 44 is disposed under the base circuit 24. The base front electrode 44 is electrically connected to the base through-electrode 27 through the base circuit 24. In an embodiment, the base front electrode 44 includes a conductive pattern 45 and a first solder interconnection 46. A base rear electrode 65 is disposed on an upper surface of the base chip 13 and is electrically connected to the base through-electrode 27.

The plurality of core chips 213, 313, 413, 513, 613, 713, and 813 may be stacked on the base chip 13. In an embodiment, the core chips 213, 313, 413, 513, 613, 713, and 813are sequentially stacked on the base chip 13. The core chips 213, 313, 413, 513, 613, 713, and 813 respectively include core substrates 222, 322, 422, 522, 622, 722, and 822; core circuits 224, 324, 424, 524, 624, 724, and 824; and core through-electrodes 227, 327, 427, 527, 627, 727, and 827.

One of the core front electrodes 245, 345, 445, 545, 645, 745, and 845 is disposed below a lower surface of a corresponding one of the core chips 213, 313, 413, 513, 613, 713, and 813. In an embodiment, each of the core front electrodes 245, 345, 445, 545, 645, 745, and 845 is disposed below a corresponding one of the core circuits 224, 324, 424, 524, 624, 724, and 824. Each of the core front electrodes 245, 345, 445, 545, 645, 745, and 845 is electrically connected to a corresponding one of the core through-electrodes 227, 327, 427, 527, 627, 727, and 827. A corresponding one of the core rear electrodes 265, 365, 465, 565, 665, 765, and 865 is disposed on an upper surface of each of the core chips 213, 313, 413, 513, 613, 713, and 813. Each of the core rear electrodes 265, 365, 465, 565, 665, 765, and 865 is electrically connected to a corresponding one of the core through-electrodes 227, 327, 427, 527, 627, 727, and 827.

The top chip 113 is stacked on the seventh core chip 813. The top chip 113 is referred to as an uppermost chip. The top chip 113 includes a top substrate 122, a top circuit 124, and a top auxiliary structure 134. The top chip 113 includes a second active region 115 and a second peripheral region 117. The top substrate 122 extends from the second active region 115 to the second peripheral region 117. The top circuit 124 is disposed under the top substrate 122 in the second active region 115. The top auxiliary structure 134 is disposed under the top substrate 122 in the second peripheral region 117 and is continuous with a side of the top circuit 124.

A top front electrode 144 is disposed under a lower surface of the top chip 113. In an embodiment, the top front electrode 144 is disposed under the top circuit 124. Second to ninth solder interconnections 246, 346, 446, 546, 646, 746, 846, and 146 are disposed between the base chip 13, the plurality of core chips 213, 313, 413, 513, 613, 713, and 813, and the top chip 113.

The solder interconnections 246, 346, 446, 546, 646, 746, 846, and 146 are respectively disposed between the base rear electrode 65 and the first core front electrode 245; the first core rear electrode 265 and the second core front electrode 345; the second core rear electrode 365 and the third core front electrode 445; the third core rear electrode 465 and the fourth core front electrode 545; the fourth core rear electrode 565 and the fifth core front electrode 645; the fifth core rear electrode 665 and the sixth core front electrode 745; the sixth core rear electrode 765 and the seventh core front electrode 845; and the seventh core rear electrode 865 and the top front electrode 144.

The encapsulation layer 96 is disposed between the base chip 13 and the top chip 113. The encapsulation layer 96 covers the plurality of core chips 213, 313, 413, 513, 613, 713, and 813. In an embodiment, the encapsulation layer 96 may extend between the base chip 13, the plurality of core chips 213, 313, 413, 513, 613, 713, and 813, and the top chip 113.

In an embodiment, the top chip 113 has a greater or larger horizontal width than the horizontal width of the base chip 13. A horizontal width includes a width in a first direction. Each of the plurality of core chips 213, 313, 413, 513, 613, 713, and 813 has substantially the same horizontal width. The base chip 13 has a greater or larger horizontal width than the horizontal width of each of the plurality of core chips 213, 313, 413, 513, 613, 713, and 813. The top chip 113 has a greater or larger horizontal width than the horizontal width of each of the plurality of core chips 213, 313, 413, 513, 613, 713, and 813. The encapsulation layer 96 extends over a side surface of the base chip 13. The encapsulation layer 96 covers the residual adhesive layer 55R and fills the groove 17G. The residual adhesive layer 55R is trapped between the base chip 13 and the encapsulation layer 96. A side surface of the encapsulation layer 96 and a side surface of the top chip 113 are substantially coplanar.

In FIG. 1, the semiconductor package includes the solder interconnections 246, 346, 446, 546, 646, 746, 846, and 146. In another embodiment, the semiconductor package may not include the solder interconnections 246, 346, 446, 546, 646, 746, 846, and 146. In this example, the base rear electrode 65 and each of the core rear electrodes 265, 365, 465, 565, 665, 765, and 865 contacts a corresponding one of the core front electrodes 245, 345, 445, 545, 645, 745, and 845 and the top front electrode 144.

In an embodiment, the base chip 13 includes a logic circuit. The base chip 13 includes a TSV region, a PHY region, and a DFT (Design For Test) region. The TSV region includes a region in which the base through-electrodes 27 are disposed for communication with the core chips 213, 313, 413, 513, 613, 713, and 813 and the top chip 113. The base chip 13 transmits to and receives data from the core chips 213, 313, 413, 513, 613, 713, and 813 and the top chip 113 or provides commands and addresses to the core chips 213, 313, 413, 513, 613, 713, and 813 and the top chip 113 through the TSV region. The PHY region includes a region in which input/output circuits are disposed for communication with an external device, such as a processor, of the semiconductor package. Signals received by the semiconductor package from the external device are transmitted to the TSV region through the PHY region and distributed to the core chips 213, 313, 413, 513, 613, 713, and 813 and the top chip 113 via the base through-electrode 27 and the core through-electrodes 227, 327, 427, 527, 627, 727, and 827. The DFT region may directly communicate with an external test device via external test pads during a test mode. Signals provided by the test device are transmitted to the TSV region through the DFT region and distributed to the core chips 213, 313, 413, 513, 613, 713, 813 and the top chip 113 via the base through-electrode 27 and the core through-electrodes 227, 327, 427, 527, 627, 727, and 827.

The core chips 213, 313, 413, 513, 613, 713, and 813 may include volatile memory, non-volatile memory, or a combination thereof. The top chip 113 may include volatile memory, non-volatile memory, or a combination thereof. In an embodiment, the top chip 113 may include the same type of memory as the core chips 213, 313, 413, 513, 613, 713, and 813. In another embodiment, the top chip 113 may include a dummy chip.

The base substrate 22, the core substrates 222, 322, 422, 522, 622, 722, and 822, and the top substrate 122 may include a semiconductor substrate such as a single-crystal silicon substrate. The base front electrode 44 may include a solder ball, a conductive bump, a conductive pin, or a combination thereof. In an embodiment, the conductive pattern 45 may include copper (Cu), tungsten (W), tungsten nitride (WN), titanium (Ti), titanium nitride (TiN), tantalum (Ta), tantalum nitride (TaN), cobalt (Co), nickel (Ni), silver (Ag), platinum (Pt), ruthenium (Ru), gold (Au), aluminum (Al), tin (Sn), or a combination thereof. For example, the conductive pattern 45 may include a copper pillar or a nickel post. The first solder interconnection 46 may include tin (Sn), silver (Ag), copper (Cu), bismuth (Bi), indium (In), zinc (Zn), gold (Au), palladium (Pd), antimony (Sb), or a combination thereof. The base through-electrode 27 and the core through-electrodes 227, 327, 427, 527, 627, 727, and 827 may include tungsten (W), tungsten nitride (WN), titanium (Ti), titanium nitride (TiN), tantalum (Ta), tantalum nitride (TaN), cobalt (Co), nickel (Ni), silver (Ag), platinum (Pt), ruthenium (Ru), copper (Cu), or a combination thereof.

The base rear electrode 65, the core front electrodes 245, 345, 445, 545, 645, 745, and 845, the core rear electrodes 265, 365, 465, 565, 665, 765, and 865, and the top front electrode 144 may include nickel (Ni), copper (Cu), cobalt (Co), tungsten (W), tungsten nitride (WN), titanium (Ti), titanium nitride (TiN), tantalum (Ta), tantalum nitride (TaN), silver (Ag), platinum (Pt), ruthenium (Ru), or a combination thereof. The solder interconnections 246, 346, 446, 546, 646, 746, 846, and 146 may include tin (Sn), silver (Ag), copper (Cu), bismuth (Bi), indium (In), zinc (Zn), gold (Au), palladium (Pd), antimony (Sb), or a combination thereof.

Referring to FIG. 2, the base chip 13 includes the base substrate 22, the base circuit 24, the base through-electrode 27, an insulating spacer 28, and the base auxiliary structure 34. The base substrate 22 has a first surface 22S 1 on a lower side and a second surface 22S2 on an upper side, where the first side and the second side are on opposite sides of the base substrate 22. The base chip 13 includes a first active region 15 and a first peripheral region 17. The first peripheral region 17 is continuous with a side of the first active region 15. The first peripheral region 17 includes a scribe lane. The base substrate 22 extends from the first active region 15 to the first peripheral region 17.

The base circuit 24 includes a logic circuit. The base circuit 24 is disposed within the first active region 15. The base circuit 24 is formed adjacent to or below the first surface 22S 1 of the base substrate 22. The base circuit 24 includes a plurality of first wiring layers 25 and a plurality of first insulating layers 26. The base through-electrode 27 extends through the base substrate 22 and is connected to the first wiring layers 25. The insulating spacer 28 is formed to surround a side of the base through-electrode 27. The base auxiliary structure 34 is disposed in the first peripheral region 17. The base auxiliary structure 34 is continuous with a side of the base circuit 24. The base auxiliary structure 34 is formed adjacent to the first surface 22S1 of the base substrate 22. The base auxiliary structure 34 includes a first auxiliary wiring layer 35 and a plurality of first auxiliary insulating layers 36.

A groove 17G is formed in the first peripheral region 17 of the base chip 13. The groove 17G is formed at an edge of the base chip 13. The groove 17G extends through the base auxiliary structure 34. In an embodiment, the groove 17G extends through the base auxiliary structure 34 and extends into the base substrate 22. The residual adhesive layer 55R is disposed in the groove 17G. The residual adhesive layer 55R contacts a side of the base auxiliary structure 34. In an embodiment, the residual adhesive layer 55R contacts the base substrate 22. The residual adhesive layer 55R partially fills the groove 17G, and the encapsulation layer 96 fills a section of the groove 17G not filled by the residual adhesive layer 55R. The encapsulation layer 96 covers the residual adhesive layer 55R.

The base front electrode 44 is disposed below the base circuit 24. The base front electrode 44 is connected to the first wiring layer 25. The base front electrode 44 is electrically connected to the base through-electrode 27 through the first wiring layer 25. In an embodiment, the base front electrode 44 includes a first conductive pattern 45 and a first solder interconnection 46. The first conductive pattern 45 is disposed between the first solder interconnection 46 and the first wiring layer 25.

A base rear electrode 65 and a base rear insulating layer 66 is formed on a second surface 22S2 of the base substrate 22. The base rear electrode 65 is connected to the base through-electrode 27. In an embodiment, the base rear insulating layer 66 includes a base rear intermediate insulating layer 66A. The base rear intermediate insulating layer 66A covers the second surface 22S2 of the base substrate 22. The base rear electrode 65 is disposed on the base rear intermediate insulating layer 66A. The base through-electrode 27 extends through the base rear intermediate insulating layer 66A and contacts the base rear electrode 65.

The first core chip 213 includes a first core substrate 222, a first core circuit 224, a first core through-electrode 227, and a first core insulating spacer 228. The first core circuit 224 includes a plurality of first core wiring layers 225 and a plurality of first core insulating layers 226. The first core through-electrode 227 vertically extends through the first core substrate 222 and is connected to the first core wiring layer 225.

A first core front electrode 245 is disposed below the first core circuit 224. The first core front electrode 245 is connected to the first core wiring layer 225. The first core front electrode 245 is connected to the first core through-electrode 227 via the first core wiring layer 225. A second solder interconnection 246 is disposed between the base rear electrode 65 and the first core front electrode 245.

A first core rear electrode 265 and a first core rear insulating layer 266 are formed on a surface of the first core substrate 222. The first core rear electrode 265 is connected to the first core through-electrode 227. In an embodiment, the first core rear insulating layer 266 includes a first core rear intermediate insulating layer 266A. The first core rear intermediate insulating layer 266A covers the first core substrate 222. The first core rear electrode 265 is be disposed on the first core rear intermediate insulating layer 266A. The first core through-electrode 227 extends through the first core rear intermediate insulating layer 266A and contacts the first core rear electrode 265.

The second core chip 313 has a configuration similar to the configuration of the first core chip 213. The second core chip 313 includes a second core substrate 322, a second core circuit 324, a second core through-electrode 327, and a second core insulating spacer 328. The second core circuit 324 includes a plurality of second core wiring layers 325 and a plurality of second core insulating layers 326. A second core front electrode 345 is disposed below the second core circuit 324. The second core front electrode 345 is connected to the second core wiring layer 325. A third solder interconnection 346 is disposed between the first core rear electrode 265 and the second core front electrode 345.

The first core circuit 224 and the second core circuit 324 may include volatile memory, non-volatile memory, or a combination thereof. In an embodiment, the first core circuit 224 and the second core circuit 324 may include volatile memory such as DRAM.

The encapsulation layer 96 covers side surfaces of the first core chip 213 and the second core chip 313 and extends over a side surface of the base chip 13. The encapsulation layer 96 extends between the base chip 13 and the first core chip 213 and between the first core chip 213 and the second core chip 313. The encapsulation layer 96 contacts side surfaces of the base rear electrode 65, the first core front electrode 245, the second solder interconnection 246, the first core rear electrode 265, the second core front electrode 345, and the third solder interconnection 346.

In an embodiment, a surface of the encapsulation layer 96 is substantially level or even with a surface of the base chip 13, such as the lower surface. The residual adhesive layer 55R is disposed between the encapsulation layer 96 and the base chip 13.

The residual adhesive layer 55R may include polyolefin, polydimethylsiloxane, siloxane-phenyl copolymer, or a combination thereof. The encapsulation layer 96 may include an epoxy molding compound. The encapsulation layer 96 may include a filler, a resin, carbon black, or a combination thereof. The filler may include silica, alumina, or a combination thereof. The filler may include a spherical filler.

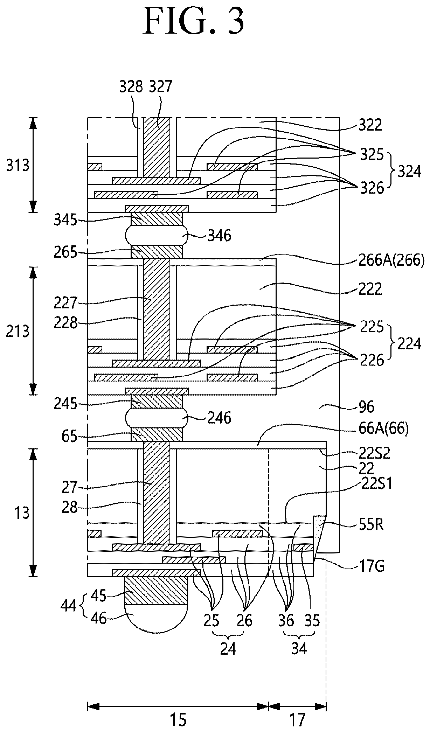

FIG. 3 to FIG. 6 are enlarged views illustrating a semiconductor package according to an embodiment of the present disclosure.

Referring to FIG. 3, in an embodiment, a lower end of the encapsulation layer 96 is disposed at a level higher than a lower surface of the base chip 13. The encapsulation layer 96 covers a side surface of the base substrate 22, the residual adhesive layer 55R, and an upper side surface of the base auxiliary structure 34, and a lower side surface of the base auxiliary structure 34 is exposed. The residual adhesive layer 55R is disposed between the encapsulation layer 96 and the base chip 13. The residual adhesive layer 55R extends to the lower side surface of the base auxiliary structure 34 as formed within the groove 17G. The encapsulation layer 96 does not cover all of the residual adhesive layer 55R in this example.

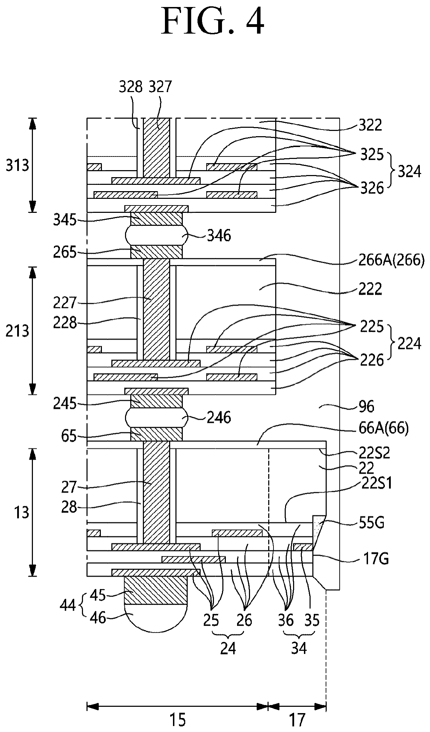

Referring to FIG. 4, in an embodiment, a lower end of the encapsulation layer 96 protrudes or extends to a level lower than a lower surface of the base chip 13. The lower end of the encapsulation layer 96 is disposed at a level higher than a lower end of the base front electrode 44. The residual adhesive layer 55R is disposed between the encapsulation layer 96 and the base chip 13.

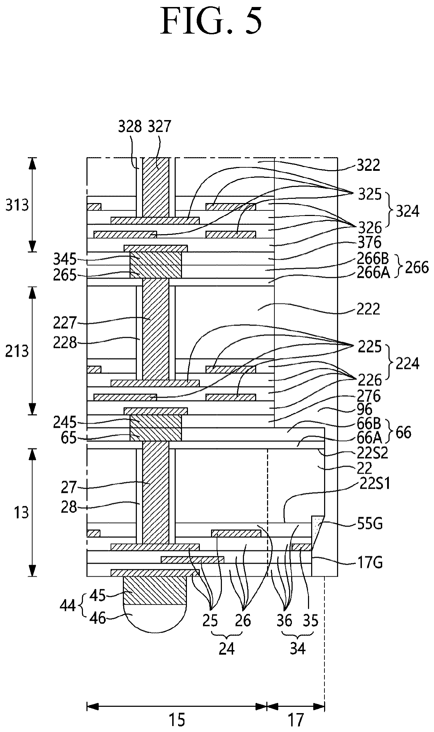

Referring to FIG. 5, in an embodiment, the base rear insulating layer 66 include a base rear intermediate insulating layer 66A and a base rear bonding insulating layer 66B. The base rear electrode 65 is disposed within the base rear bonding insulating layer 66B. An upper surface of the base rear electrode 65 and an upper surface of the base rear bonding insulating layer 66B are substantially coplanar.

A first core front bonding insulating layer 276 is disposed below the first core circuit 224. The first core front electrode 245 is disposed within the first core front bonding insulating layer 276. A lower surface of the first core front electrode 245 and a lower surface of the first core front bonding insulating layer 276 are substantially coplanar.

The first core chip 213 is bonded to the base chip 13. The first core front bonding insulating layer 276 is to the base rear bonding insulating layer 66B, and the first core front electrode 245 is bonded to the base rear electrode 65. The first core front bonding insulating layer 276 contacts the base rear bonding insulating layer 66B, and the first core front electrode 245 contacts the base rear electrode 65.

In an embodiment, the first core rear insulating layer 266 includes a first core rear intermediate insulating layer 266A and a first core rear bonding insulating layer 266B. The first core rear electrode 265 is disposed within the first core rear bonding insulating layer 266B. An upper surface of the first core rear electrode 265 and an upper surface of the first core rear bonding insulating layer 266B are substantially coplanar.

A second core front bonding insulating layer 376 is disposed below the second core circuit 324. The second core front electrode 345 is disposed within the second core front bonding insulating layer 376. A lower surface of the second core front electrode 345 and a lower surface of the second core front bonding insulating layer 376 are substantially coplanar.

The second core chip 313 is bonded to the first core chip 213. The second core front bonding insulating layer 376 is bonded to the first core rear bonding insulating layer 266B, and the second core front electrode 345 is bonded to the first core rear electrode 265. The second core front bonding insulating layer 376 contacts the first core rear bonding insulating layer 266B, and the second core front electrode 345 contacts the first core rear electrode 265.

In an embodiment, the base rear electrode 65, the first core front electrode 245, the first core rear electrode 265, and the second core front electrode 345 may include a copper layer formed by electroplating. Each of the base rear bonding insulating layer 66B, the first core front bonding insulating layer 276, the first core rear bonding insulating layer 266B, and the second core front bonding insulating layer 376 may include a single layer or a multilayer structure. The base rear bonding insulating layer 66B, the first core front bonding insulating layer 276, the first core rear bonding insulating layer 266B, and the second core front bonding insulating layer 376 may each include at least two elements selected from the group consisting of silicon (Si), oxygen (O), nitrogen (N), carbon (C), and boron (B). The base rear bonding insulating layer 66B, the first core front bonding insulating layer 276, the first core rear bonding insulating layer 266B, and the second core front bonding insulating layer 376 may include silicon oxide, silicon nitride, silicon oxynitride, silicon carbonitride (SiCN), silicon oxycarbonitride (SiOCN), low-k dielectric material, or a combination thereof.

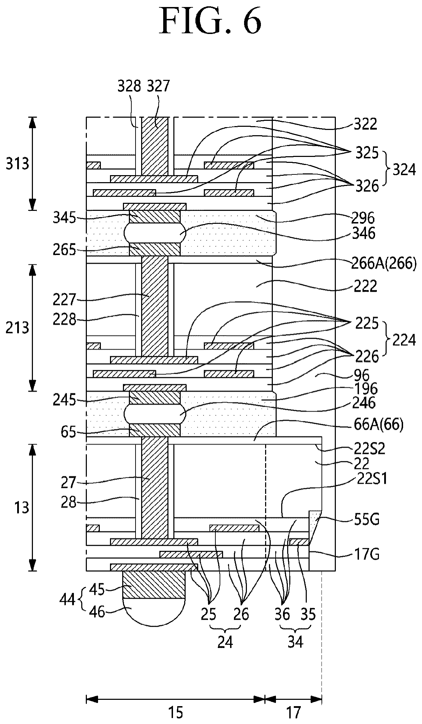

Referring to FIG. 6, in an embodiment, a first intermediate encapsulation layer 196 is disposed between the base chip 13 and the first core chip 213, and a second intermediate encapsulation layer 296 is disposed between the first core chip 213 and the second core chip 313. The first intermediate encapsulation layer 196 and the second intermediate encapsulation layer 296 may include a nonconductive film (NCF), underfill, or a combination thereof.

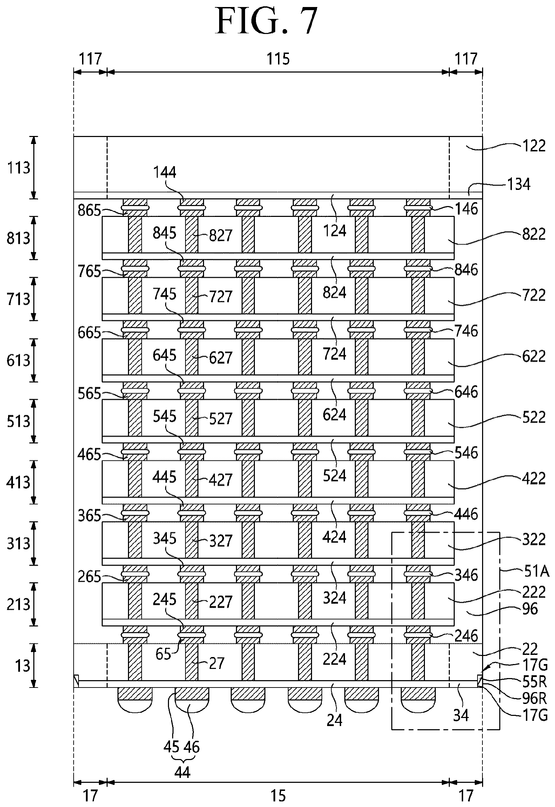

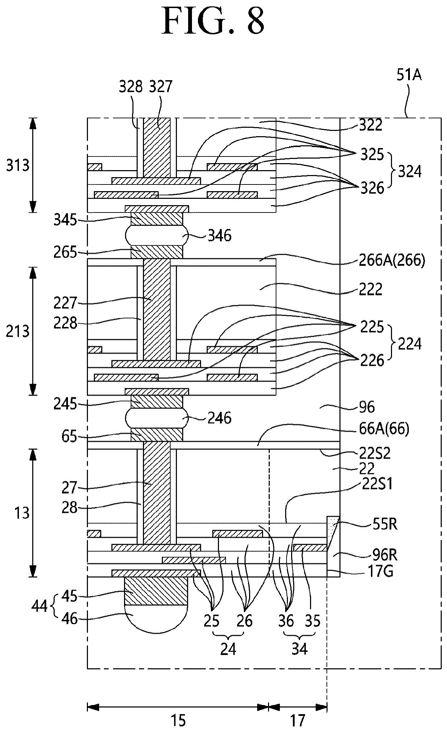

FIG. 7 is a cross-sectional view illustrating a semiconductor package according to an embodiment of the present disclosure, FIG. 8 is an enlarged view of area 51A of FIG. 7, and FIG. 9 and FIG. 10 are cross-sectional views illustrating semiconductor packages according to an embodiment of the present disclosure.

Referring to FIG. 7 and FIG. 8, the top chip 113 and the base chip 13 have substantially the same horizontal width. Each of the top chip 113 and the base chip 13 have a larger horizontal width than the horizontal width of each of the plurality of core chips 213, 313, 413, 513, 613, 713, and 813. The encapsulation layer 96 is disposed between the base chip 13 and the top chip 113. The encapsulation layer 96 covers the plurality of core chips 213, 313, 413, 513, 613, 713, and 813. A side surface of the base chip 13, a side surface of the encapsulation layer 96, and a side surface of the top chip 113 are substantially coplanar. The groove 17G extends through the base auxiliary structure 34 and extends into the base substrate 22. A residual adhesive layer 55R and a residual encapsulation layer 96R are disposed in the groove 17G. The residual adhesive layer 55R contacts the base chip 13 and partially fills the groove 17G. The residual encapsulation layer 96R covers the residual adhesive layer 55R such that the groove is filled. The residual adhesive layer 55R may be trapped between the base chip 13 and the residual encapsulation layer 96R. A side surface of the residual encapsulation layer 96R is substantially coplanar with a side surface of the base chip 13.

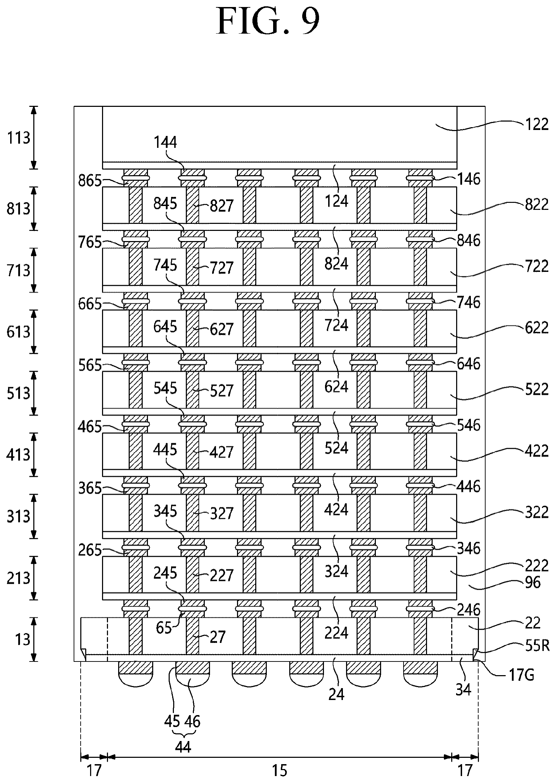

Referring to FIG. 9, in an embodiment, the top chip 113 has a smaller horizontal width than the horizontal width of the base chip 13. The top chip 113 has substantially the same horizontal width as the horizontal width of each of the plurality of core chips 213, 313, 413, 513, 613, 713, and 813. The encapsulation layer 96 covers the plurality of core chips 213, 313, 413, 513, 613, 713, and 813 and extends over a side surface of the top chip 113. The encapsulation layer 96 extends over a side surface of the base chip 13. The groove 17G extends through the base auxiliary structure 34 and extends into the base substrate 22. The residual adhesive layer 55R and the encapsulation layer 96 are disposed in the groove 17G. The residual adhesive layer 55R contacts the base chip 13 and partially fills the groove 17G, and the encapsulation layer 96 fills a a section of the groove 17G not filled by the residual adhesive layer 55R. The encapsulation layer 96 covers the residual adhesive layer 55R. The residual adhesive layer 55R may be trapped between the base chip 13 and the encapsulation layer 96.

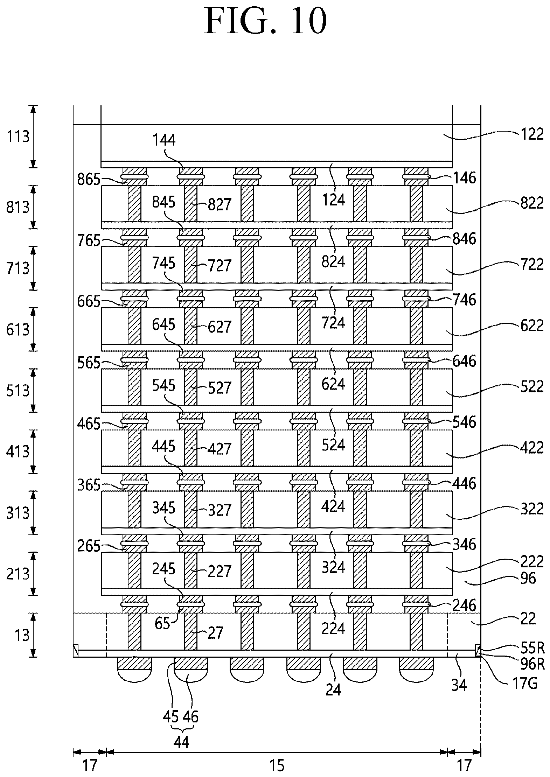

Referring to FIG. 10, the encapsulation layer 96 covers the plurality of core chips 213, 313, 413, 513, 613, 713, and 813 and extends over a side surface of the top chip 113. A side surface of the base chip 13 and a side surface of the encapsulation layer 96 are substantially coplanar. The groove 17G extends through the base auxiliary structure 34 and extends into the base substrate 22. A residual adhesive layer 55R and a residual encapsulation layer 96R are disposed in the groove 17G. The residual adhesive layer 55R contacts the base chip 13 and partially fills the groove 17G. The residual encapsulation layer 96R covers the residual adhesive layer 55R. The residual adhesive layer 55R may be trapped between the base chip 13 and the residual encapsulation layer 96R. A side surface of the residual encapsulation layer 96R is substantially coplanar with the side surface of the base chip 13 and the side surface of the encapsulation layer 96.

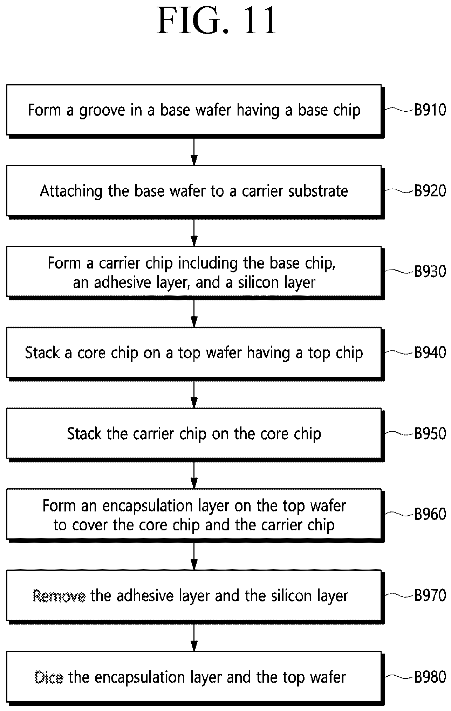

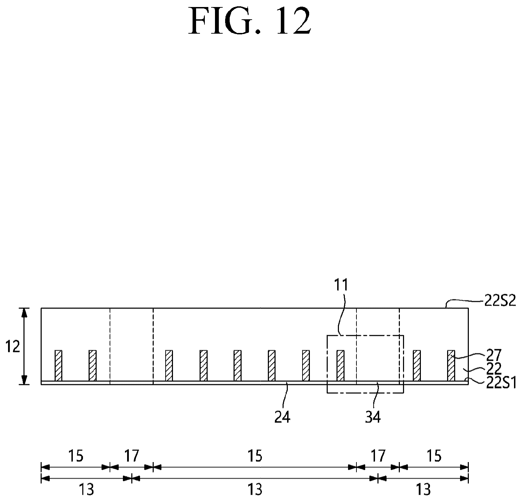

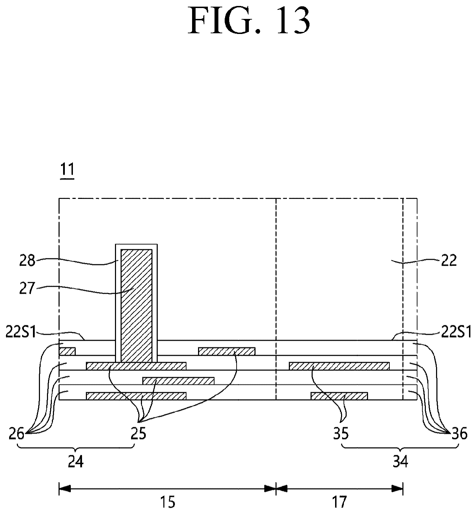

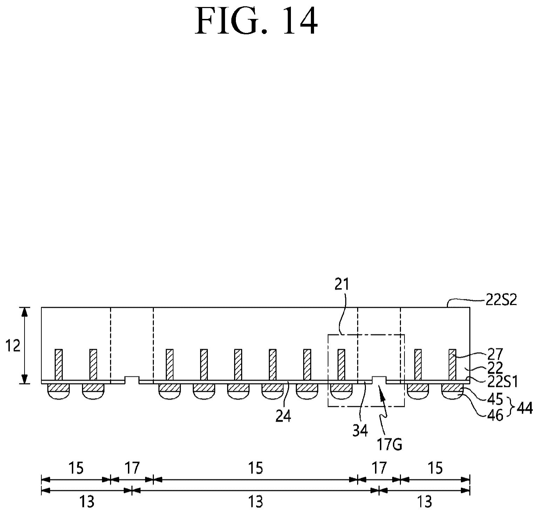

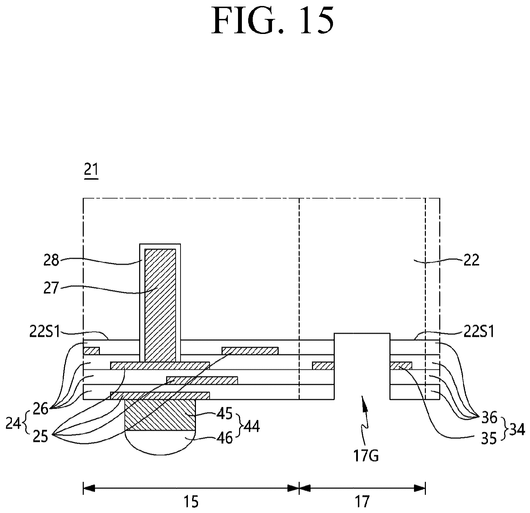

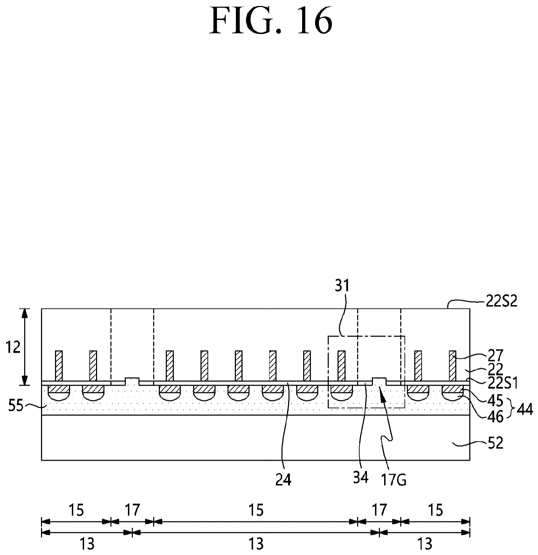

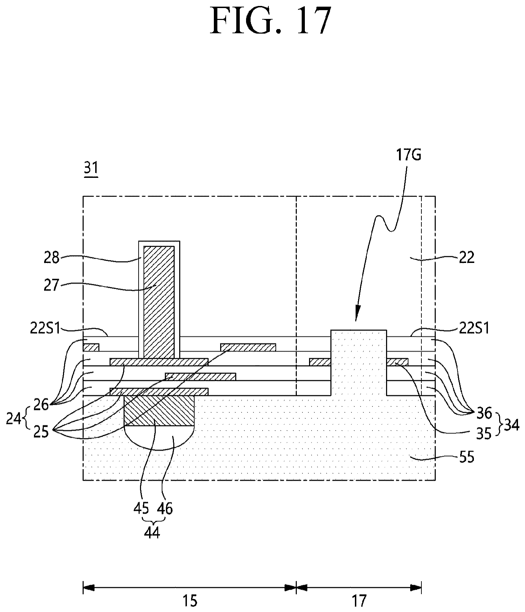

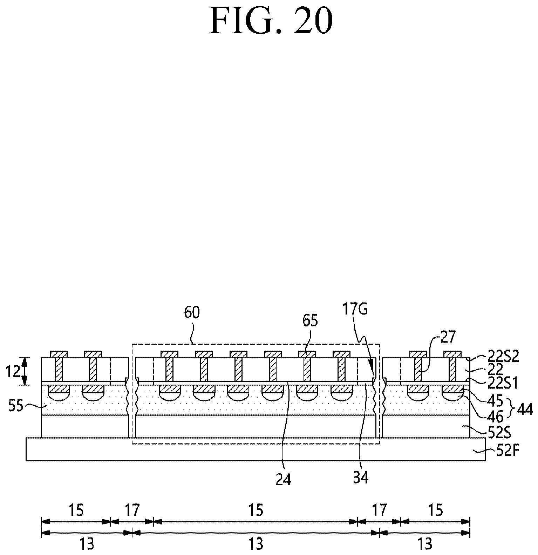

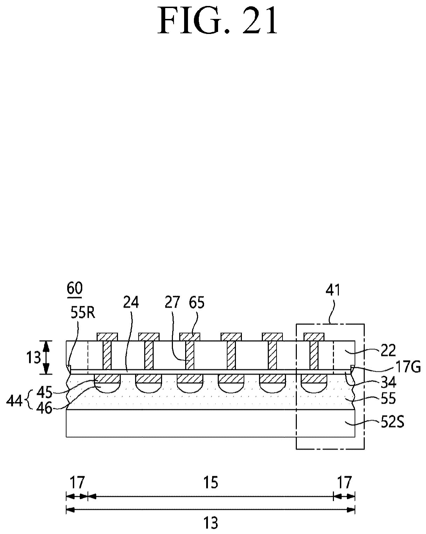

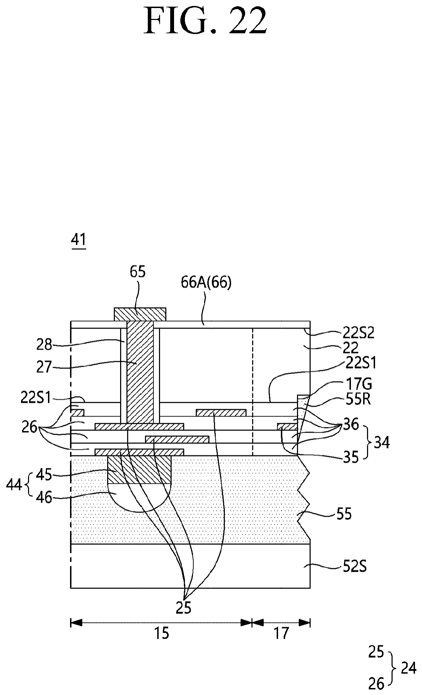

FIG. 11 is a flowchart illustrating a method of forming a semiconductor package according to an embodiment of the present disclosure. FIG. 12, FIG. 14, FIG. 16, and FIG. 18 to FIG. 20 and FIG. 25 to FIG. 31 are cross-sectional views of the method of forming a semiconductor package according to an embodiment of the present disclosure. FIG. 13 is an enlarged view of area 11 of FIG. 12. FIG. 15 is an enlarged view of area 21 of FIG. 14. FIG. 17 is an enlarged view of area 31 of FIG. 16. FIG. 21 is an enlarged view of area 60 of FIG. 20. FIG. 22 to FIG. 24 are enlarged views of area 41 of FIG. 21.

Referring to FIG. 11, a method of forming a semiconductor package according to an embodiment of the present disclosure includes: forming B910 a groove in a base wafer having a base chip; attaching B920 the base wafer to a carrier substrate; forming B930 a carrier chip including the base chip, an adhesive layer, and a silicon layer; stacking B940 a core chip on a top wafer having a top chip; stacking B950 the carrier chip on the core chip; forming B960 an encapsulation layer on the top wafer to cover the core chip and the carrier chip; removing B970 the adhesive layer and the silicon layer; and dicing B980 the encapsulation layer and the top wafer. The processes of the flowchart may be performed in a different order and may include fewer or additional processes than described and shown in FIG. 11.

Referring to FIG. 12 and FIG. 13, a base wafer 12 includes a base chip 13. The base chip 13 includes a first active region 15 and a first peripheral region 17. The base chip 13 is repeatedly arranged in rows and columns within the base wafer 12 in this example. The first peripheral region 17 is disposed between a plurality of first active regions 15. The first peripheral region 17 includes a scribe lane.

The base chip 13 includes a base substrate 22, a base circuit 24, a base through-electrode 27, an insulating spacer 28, and a base auxiliary structure 34. The base substrate 22 has a first surface 22S1 on a lower side and a second surface 22S2 on an upper side, where the first side and the second side are on opposite sides of the substrate 22. The base circuit 24 is formed under the first surface 22S1 of the base substrate 22. The base circuit 24 includes a plurality of first wiring layers 25 and a plurality of first insulating layers 26. Components of the base circuit 24 may be formed within or extend into the base substrate 22 (not shown). The base through-electrode 27 is formed in the base substrate 22 and is connected to the first wiring layer 25. An insulating spacer 28 surrounding a side of the base through-electrode 27 is formed.

The base substrate 22 extends from the first active region 15 to the first peripheral region 17. The base auxiliary structure 34 is disposed on the base substrate 22 in the first peripheral region 17. The base auxiliary structure 34 may include a test pattern, an alignment key, a vernier key, or a combination thereof. In an embodiment, the base auxiliary structure 34 is formed under the first surface 22S1 of the base substrate 22. The base auxiliary structure 34 is continuous with a side of the base circuit 24. The base auxiliary structure 34 includes a plurality of first auxiliary wiring layers 35 and a plurality of first auxiliary insulating layers 36. The plurality of first auxiliary wiring layers 35 and the plurality of first auxiliary insulating layers 36 may include material layers similar to the plurality of first wiring layers 25 and the plurality of first insulating layers 26.

Referring to FIG. 11, FIG. 14, and FIG. 15, a groove 17G is formed B910 in the base wafer 12 including the base chip 13. The groove 17G is formed in the first peripheral region 17. The groove 17G extends through the base auxiliary structure 34. In an embodiment, the groove 17G extends through the base auxiliary structure 34 and extends into the base substrate 22. A side surface of the base auxiliary structure 34 and a surface of the base substrate 22 are exposed through the groove 17G. The groove 17G may be formed using a laser grooving process, a dry etching process, a sawing process, or a combination thereof.

A base front electrode 44 is formed below the base circuit 24. The base front electrode 44 is connected to the first wiring layer 25. In an embodiment, the base front electrode 44 includes a first conductive pattern 45 and a first solder interconnection 46.

In an embodiment, the groove 17G may be formed before forming the base front electrode 44. In an embodiment, the base front electrode 44 may be formed before forming the groove 17G.

Referring to FIG. 11, FIG. 16, and FIG. 17, the adhesive layer 55 and the base wafer 12 are attached B920 to a carrier substrate 52. In an embodiment, the carrier substrate 52 may include a silicon layer such as a test wafer or a dummy wafer. In an embodiment, the silicon layer may include a single-crystal silicon layer. The adhesive layer 55 is attached between the first surface 22S1 of the base substrate 22 and the carrier substrate 52. The adhesive layer 55 extends into the groove 17G. The adhesive layer 55 may directly contact a side surface of the base auxiliary structure 34 and the base substrate 22 within the groove 17G. The adhesive layer 55 covers the base front electrode 44.

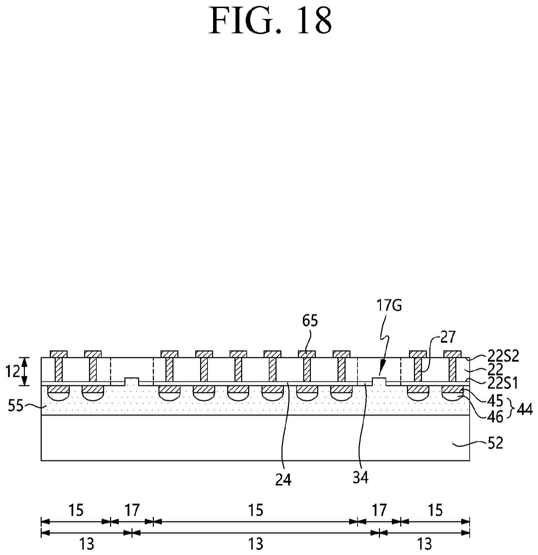

Referring to FIG. 18, the second surface 22S2 of the base substrate 22 may be recessed to expose the base through-electrode 27. The base through-electrode 27 vertically extends through the base substrate 22. A base rear electrode 65 is formed on the second surface 22S2 of the base substrate 22. The base rear electrode 65 is connected to the base through-electrode 27.

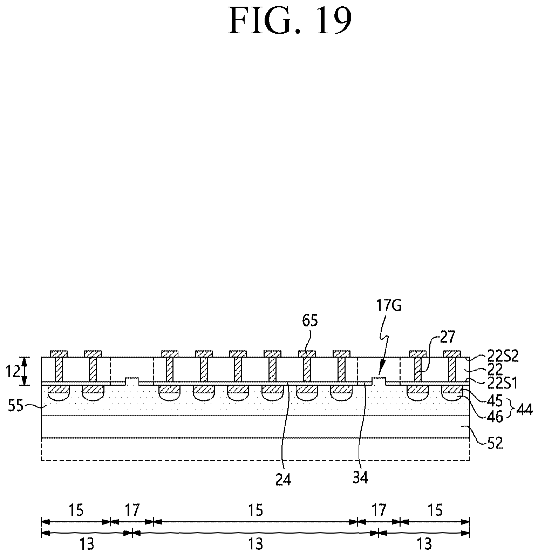

Referring to FIG. 19, the carrier substrate 52 may be partially removed to reduce its thickness.

Referring to FIG. 11 and FIG. 20, the carrier substrate 52 in FIG. 19 is adhered to a first adhesive film 52F. The carrier substrate 52 in FIG. 19, the adhesive layer 55, and the base wafer 12 are diced to form B930 a carrier chip 60. The process of forming the carrier chip 60 includes dicing the carrier substrate 52 in FIG. 19, the adhesive layer 55, and the base substrate 22 along the center of the first peripheral region 17. The carrier chip 60 includes the base chip 13, the adhesive layer 55, and a silicon layer 52S. A side surface of the adhesive layer 55 is formed during the dicing process. The side surface of the adhesive layer 55 may have roughness or irregularities.

Referring to FIG. 21 and FIG. 22, the carrier chip 60 is separated by removing the first adhesive film 52F. The groove 17G remains at an edge of the base chip 13. The adhesive layer 55 is attached between the base chip 13 and the silicon layer 52S.

The base rear insulating layer 66 includes a base rear intermediate insulating layer 66A. The base rear intermediate insulating layer 66A covers the second surface 22S2 of the base substrate 22. The base rear electrode 65 is formed on the base rear intermediate insulating layer 66A. The base through-electrode 27 vertically extends through the base substrate 22 and the base rear intermediate insulating layer 66A and is connected to the base rear electrode 65.

The adhesive layer 55 covers the base circuit 24, the base auxiliary structure 34, and the base front electrode 44. A residual adhesive layer 55R is formed in the groove 17G. The residual adhesive layer 55R partially fills the groove 17G. The residual adhesive layer 55R directly contacts a side surface of the base auxiliary structure 34 and the base substrate 22 within the groove 17G.

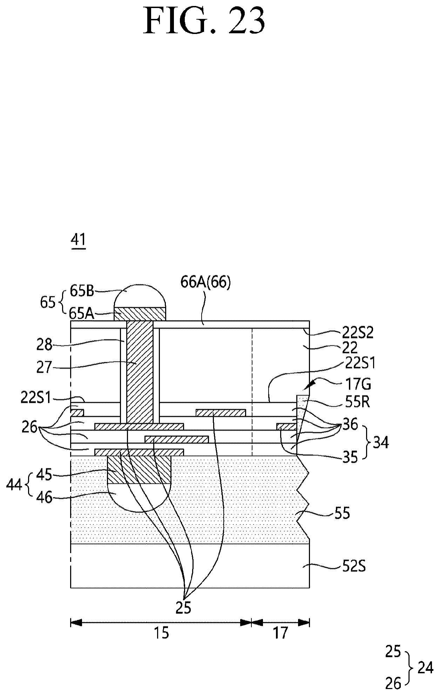

Referring to FIG. 23, the base rear insulating layer 66 includes a base rear intermediate insulating layer 66A. The base rear electrode 65 includes a first base rear electrode 65A and a second base rear electrode 65B. In an embodiment, the first base rear electrode 65A may include nickel (Ni), copper (Cu), cobalt (Co), tungsten (W), tungsten nitride (WN), titanium (Ti), titanium nitride (TiN), tantalum (Ta), tantalum nitride (TaN), silver (Ag), platinum (Pt), ruthenium (Ru), or a combination thereof. The second base rear electrode 65B may include tin (Sn), silver (Ag), copper (Cu), bismuth (Bi), indium (In), zinc (Zn), gold (Au), palladium (Pd), antimony (Sb), or a combination thereof. The base through-electrode 27 is connected to the first base rear electrode 65A. The second base rear electrode 65B is formed on the first base rear electrode 65A.

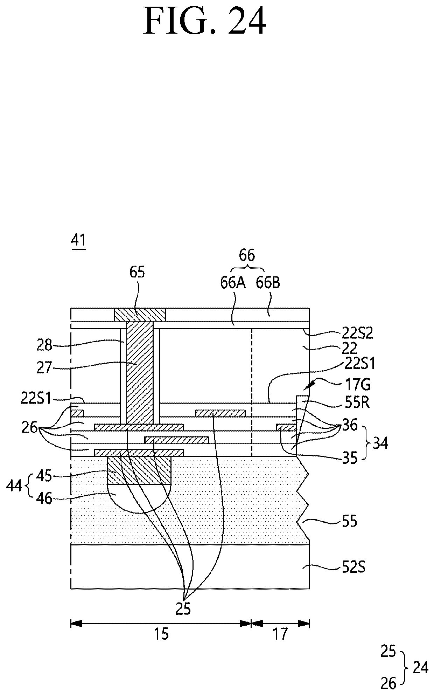

Referring to FIG. 24, the base rear insulating layer 66 includes a base rear intermediate insulating layer 66A and a base rear bonding insulating layer 66B. The base rear electrode 65 is formed within the base rear bonding insulating layer 66B. An upper surface of the base rear electrode 65 and an upper surface of the base rear bonding insulating layer 66B are substantially coplanar.

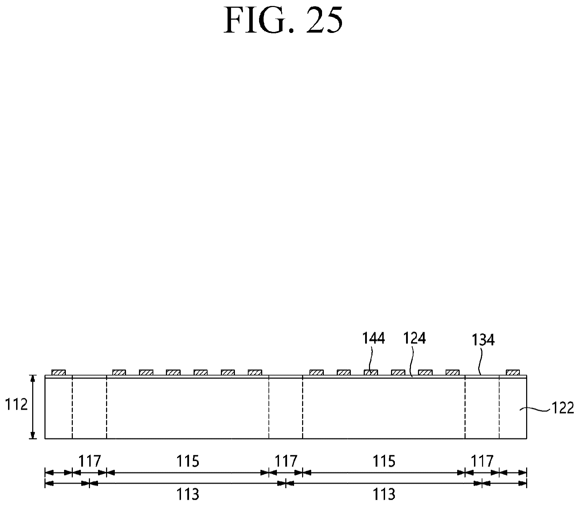

Referring to FIG. 25, a top wafer 112 includes a top chip 113. The top chip 113 is repeatedly arranged in rows and columns within the top wafer 112. The top chip 113 includes a second active region 115 and a second peripheral region 117. The second peripheral region 117 is continuous with an outer side of the second active region 115 and is disposed between a plurality of second active regions 115. The second peripheral region 117 includes a scribe lane.

The top chip 113 includes a top substrate 122, a top circuit 124, and a top auxiliary structure 134. The top circuit 124 is formed adjacent to an upper surface of the top substrate 122. The top circuit 124 may include volatile memory, non-volatile memory, or a combination thereof. In an embodiment, the top circuit 124 may include volatile memory such as DRAM. In an embodiment, the top chip 113 includes a dummy chip.

The top substrate 122 is disposed in the second active regions 115 and the second peripheral regions 117. The top auxiliary structure 134 is disposed on the top substrate 122 in the second peripheral region 117. The top auxiliary structure 134 may include a test pattern, an alignment key, a vernier key, or a combination thereof. The top auxiliary structure 134 is continuous with a side of the top circuit 124.

A top front electrode 144 is formed on the top circuit 124. The top front electrode 144 is connected to the top circuit 124.

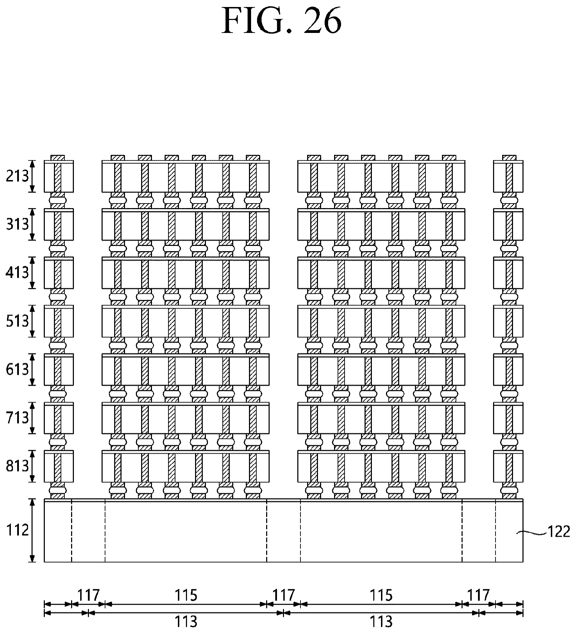

Referring to FIG. 11 and FIG. 26, a plurality of core chips 213, 313, 413, 513, 613, 713, and 813 are stacked B940 on the top wafer 112 having the top chip 113. In an embodiment, the seventh core chip 813, the sixth core chip 713, the fifth core chip 613, the fourth core chip 513, the third core chip 413, the second core chip 313, and the first core chip 213 are sequentially stacked on the top chip 113. In an embodiment, the first core chip 213 is the topmost or uppermost core chip.

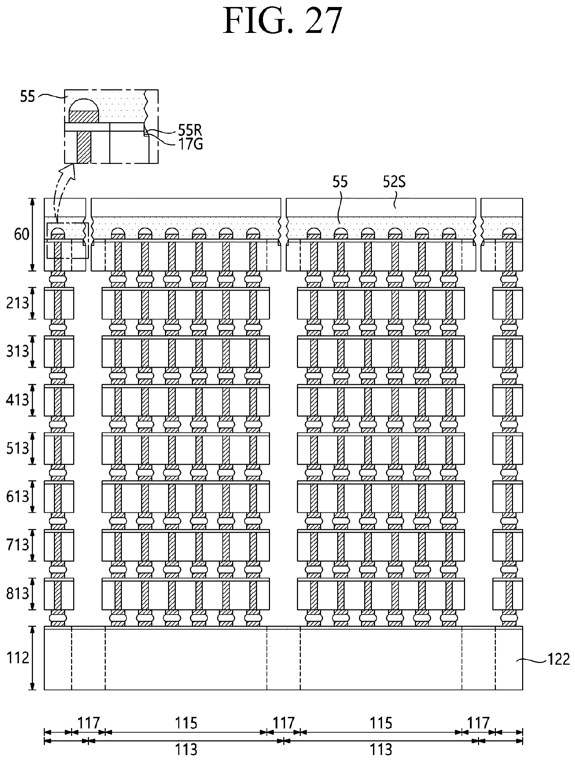

Referring to FIG. 11 and FIG. 27, a carrier chip 60 is stacked B950 on the topmost core chip, the first core chip 213.

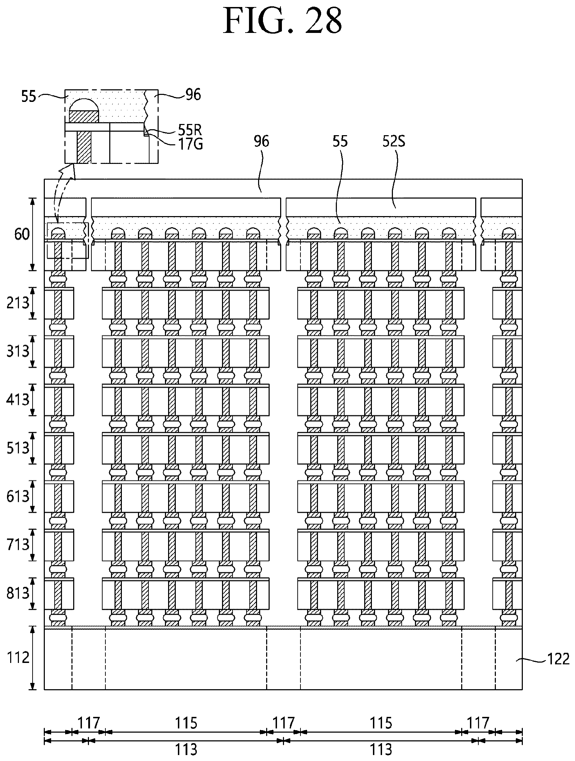

Referring to FIG. 11 and FIG. 28, an encapsulation layer 96 is formed B960 on the top wafer 112 to cover the plurality of core chips 213, 313, 413, 513, 613, 713, 813 and the carrier chip 60. The encapsulation layer 96 fills the groove 17G. The residual adhesive layer 55R is covered by the encapsulation layer 96.

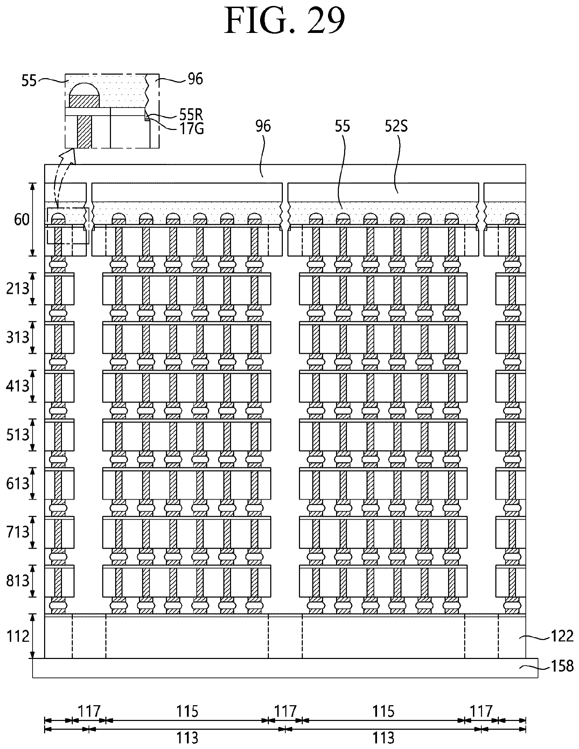

Referring to FIG. 29, a second adhesive film 158 is attached below a lower surface of the top wafer 112.

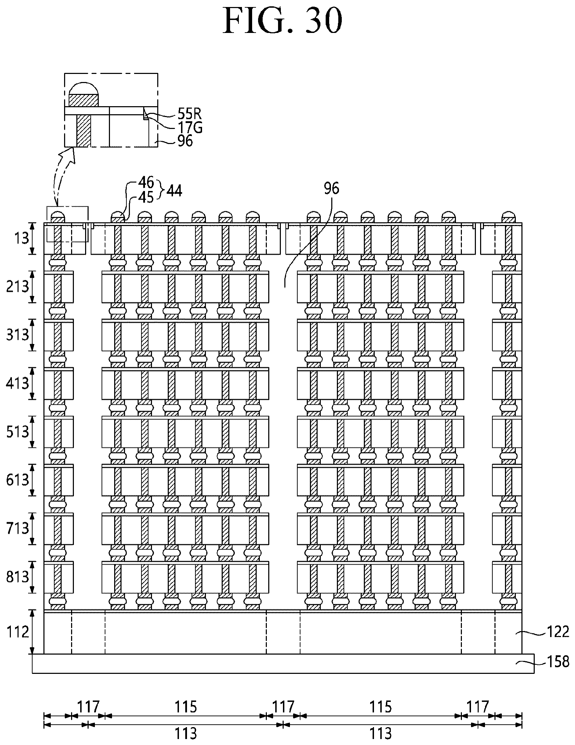

Referring to FIG. 11 and FIG. 30, the adhesive layer 55 in FIG. 29 and the silicon layer 52S in FIG. 29 are removed B970. During the process of removing the adhesive layer 55 in FIG. 29 and the silicon layer 52S as shown in FIG. 29, the encapsulation layer 96 is partially removed. As the adhesive layer and the silicon layer are removed, the base front electrode 44 is exposed. After the adhesive layer and the silicon layer are removed, the residual adhesive layer 55R and the encapsulation layer 96 remain in the groove 17G.

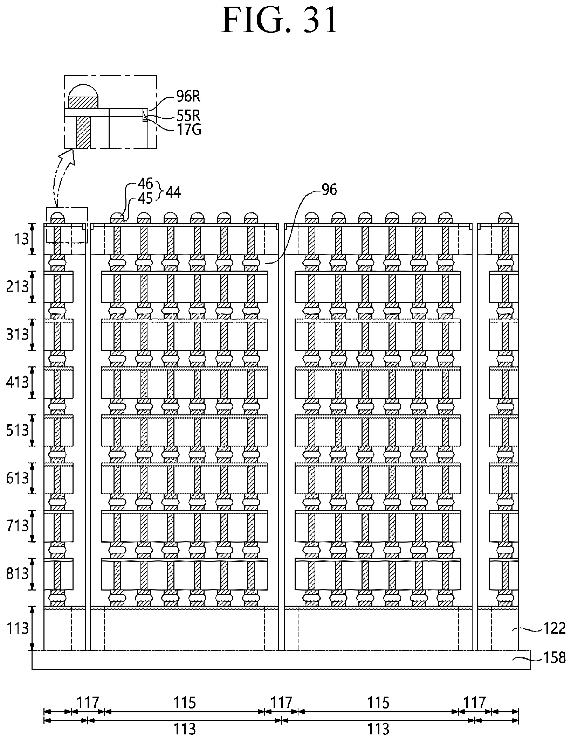

Referring to FIG. 11 and FIG. 31, the encapsulation layer 96 and the top wafer 112 are diced B980 to separate the semiconductor packages.

According to an embodiment of the present disclosure, the base chips 13 included in the base wafer 12 are identified as good chips or defective chips. The carrier chip 60 includes one base chip 13. A carrier chip 60 including a good base chip 13 is selectively stacked on a topmost core chip, such as the first core chip 213. Compared to a method in which a plurality of core chips 213, 313, 413, 513, 613, 713, and 813 are stacked on the base wafer 12, the mass production efficiency of semiconductor packages may be improved utilized the methods of the present disclosure.

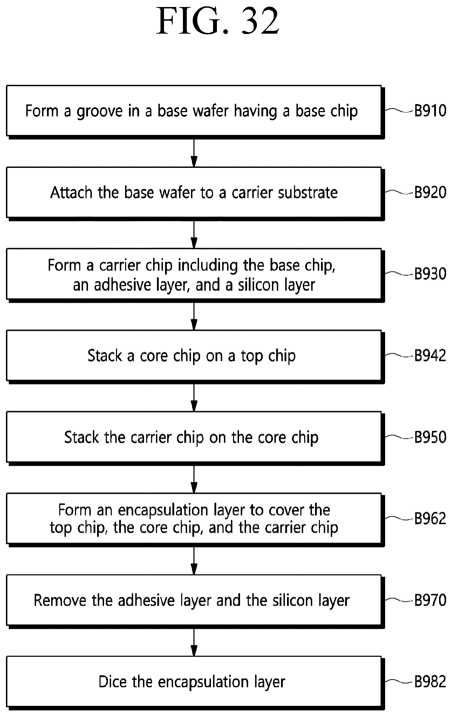

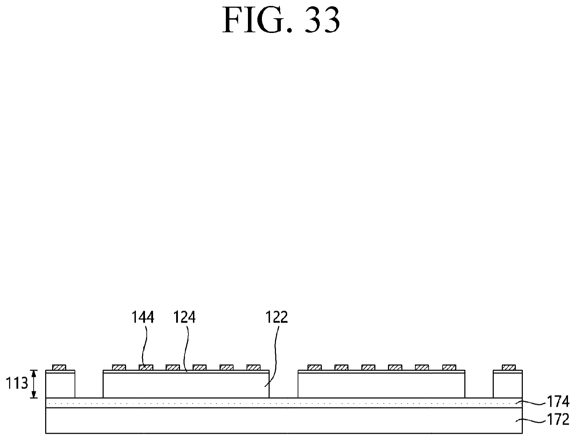

FIG. 32 is a flowchart illustrating a method of forming a semiconductor package according to an embodiment of the present disclosure. FIG. 33 to FIG. 36 are cross-sectional views illustrating the semiconductor package formed utilizing a method according to an embodiment of the present disclosure.

Referring to FIG. 32, a method of forming a semiconductor package according to an embodiment of the present disclosure includes: forming B910 a groove in a base wafer having a base chip; attaching B920 the base wafer to a carrier substrate; forming B930 a carrier chip including the base chip, an adhesive layer, and a silicon layer; stacking B942 a core chip on a top chip; stacking B950 the carrier chip on the core chip; forming B962 an encapsulation layer to cover the top chip, the core chip, and the carrier chip; removing B970 the adhesive layer and the silicon layer; and dicing B982 the encapsulation layer. The processes of the flowchart may be performed in a different order and may include fewer or additional processes than described and shown in FIG. 32. The differences from FIG. 11 to FIG. 31 are described.

Referring to FIG. 33, a first buffer layer 174 is formed on a first carrier 172. The top chip 113 is attached to the first buffer layer 174. The top chip 113 is repeatedly arranged at regular intervals in rows and columns on the first carrier 172.

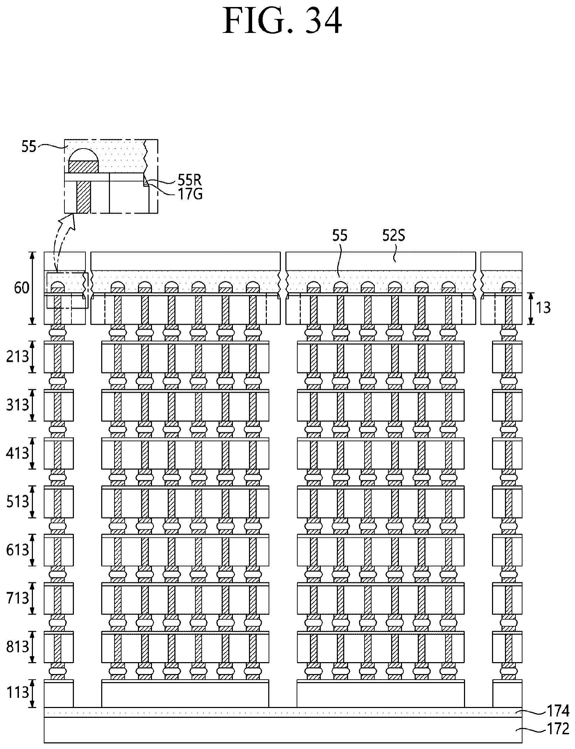

Referring to FIG. 32 and FIG. 34, a plurality of core chips 213, 313, 413, 513, 613, 713, and 813 are stacked B942 on the top chip 113. The carrier chip 60 is stacked B950 on the first core chip 213. The carrier chip 60 includes the base chip 13, the adhesive layer 55, the silicon layer 52S, the groove 17G, and the residual adhesive layer 55R. The residual adhesive layer 55R is disposed in the groove 17G and partially fills the groove 17G.

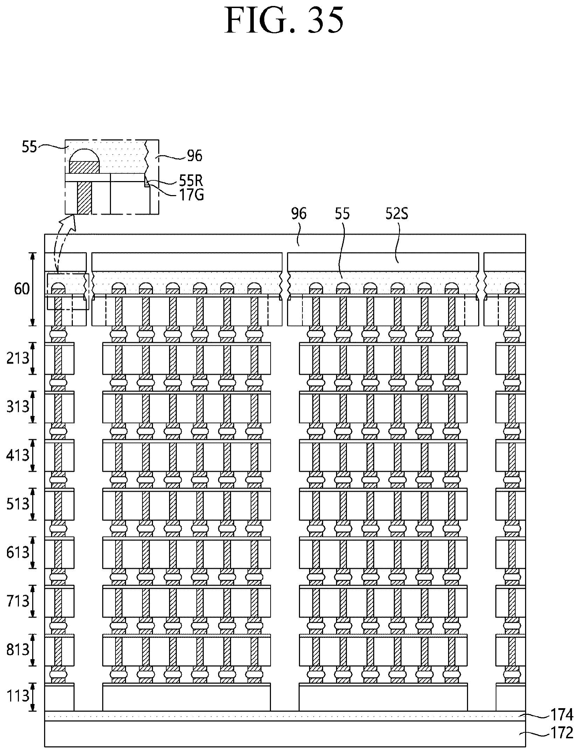

Referring to FIG. 32 and FIG. 35, the encapsulation layer 96 is formed B962 to cover the top chip 113, the plurality of core chips 213, 313, 413, 513, 613, 713, and 813, and the carrier chip 60. The groove 17G is filled with the residual adhesive layer 55R and the encapsulation layer 96. The residual adhesive layer 55R may be trapped between the base chip 13 and the encapsulation layer 96.

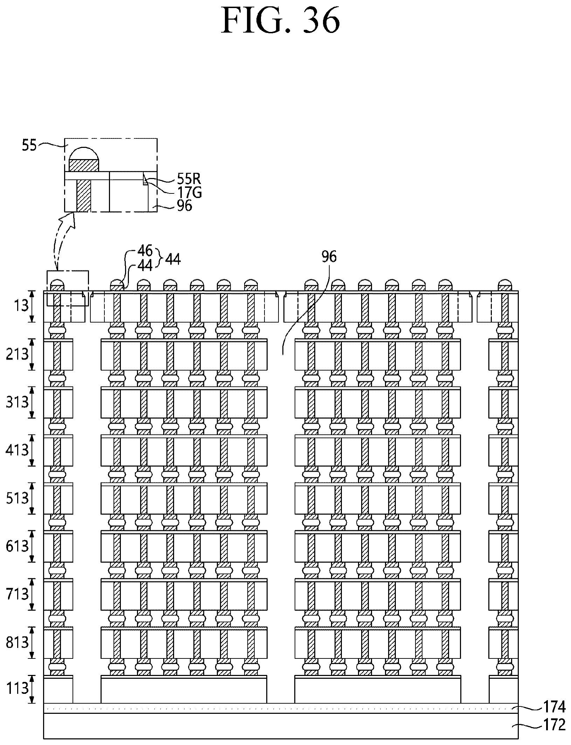

Referring to FIG. 32 and FIG. 36, the adhesive layer 55 and the silicon layer 52S are removed B970.

As described with reference to FIG. 31, the encapsulation layer 96 is diced to separate the semiconductor package B982.

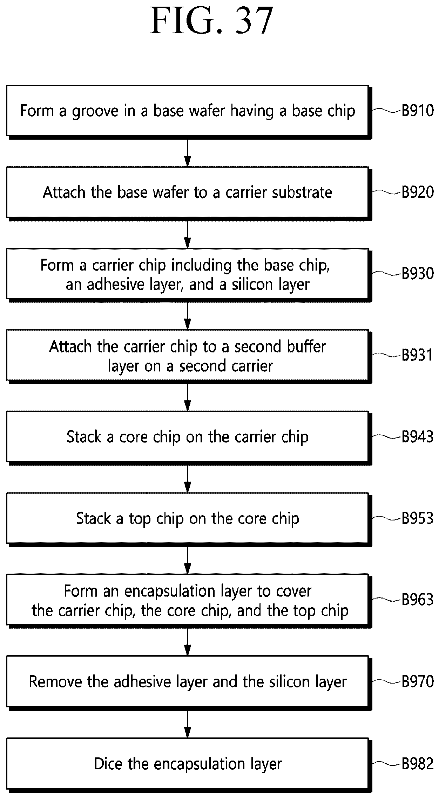

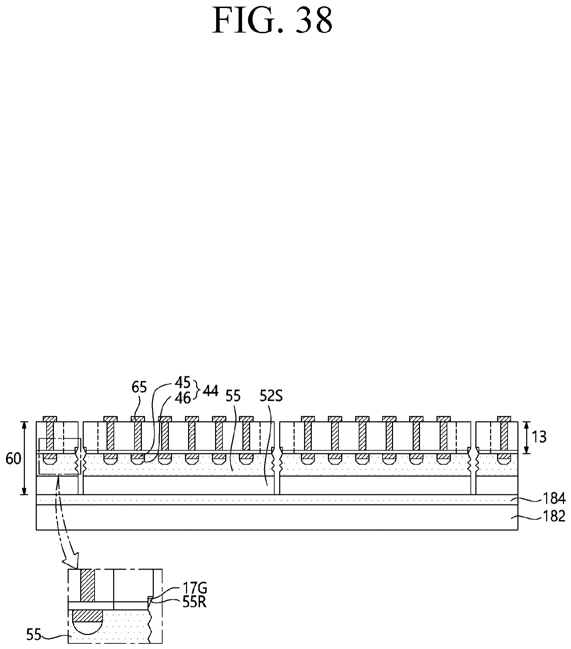

FIG. 37 is a flowchart illustrating a method of forming a semiconductor package according to an embodiment of the present disclosure. FIG. 38 to FIG. 40 are cross-sectional views of the semiconductor package formed utilizing the method according to an embodiment of the present disclosure.

Referring to FIG. 37, a method of forming a semiconductor package according to an embodiment of the present disclosure includes: forming B910 a groove in a base wafer having a base chip; attaching B920 the base wafer to a carrier substrate; forming B930 a carrier chip including the base chip, an adhesive layer, and a silicon layer; attaching B931 the carrier chip to a second buffer layer formed on a second carrier; stacking B943 a core chip on the carrier chip; stacking B953 a top chip on the core chip; forming B963 an encapsulation layer to cover the carrier chip, the core chip, and the top chip; removing B970 the adhesive layer and the silicon layer; and dicing B982 the encapsulation layer. The processes of the flowchart may be performed in a different order and may include fewer or additional processes than described and shown in FIG. 37. Differences from FIG. 10 to FIG. 35 are described.

Referring to FIG. 38, a second buffer layer 184 is formed on a second carrier 182. The carrier chip 60 is attached to the second buffer layer 184. The carrier chips 60 is repeatedly arranged in rows and columns on the second carrier 182 at regular intervals. The carrier chip 60 includes the base chip 13, the adhesive layer 55, the silicon layer 52S, the groove 17G, and the residual adhesive layer 55R. The residual adhesive layer 55R partially fills the groove 17G.

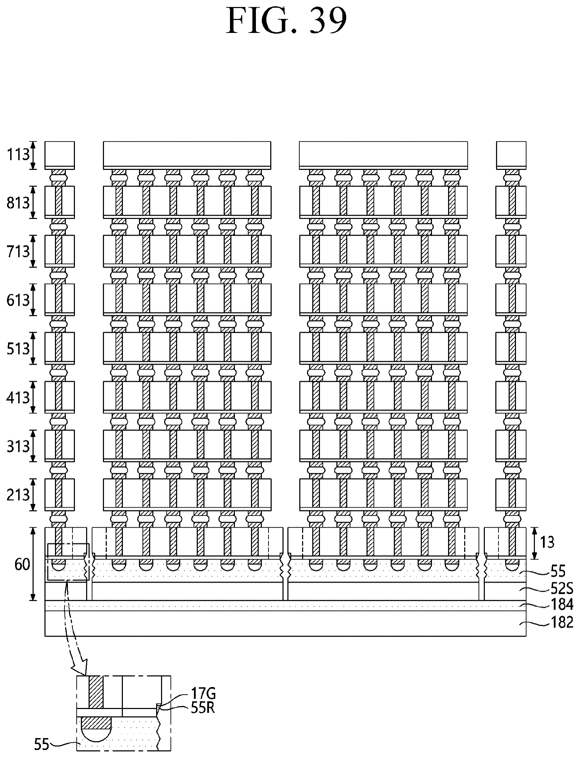

Referring to FIG. 37 and FIG. 39, a plurality of core chips 213, 313, 413, 513, 613, 713, and 813 are stacked on the carrier chip 60 (B943). In an embodiment, the first core chip 213, the second core chip 313, the third core chip 413, the fourth core chip 513, the fifth core chip 613, the sixth core chip 713, and the seventh core chip 813 are sequentially stacked on the carrier chip 60. The seventh core chip 813 is the topmost core chip. The top chip 113 is stacked B953 on the seventh core chip 813.

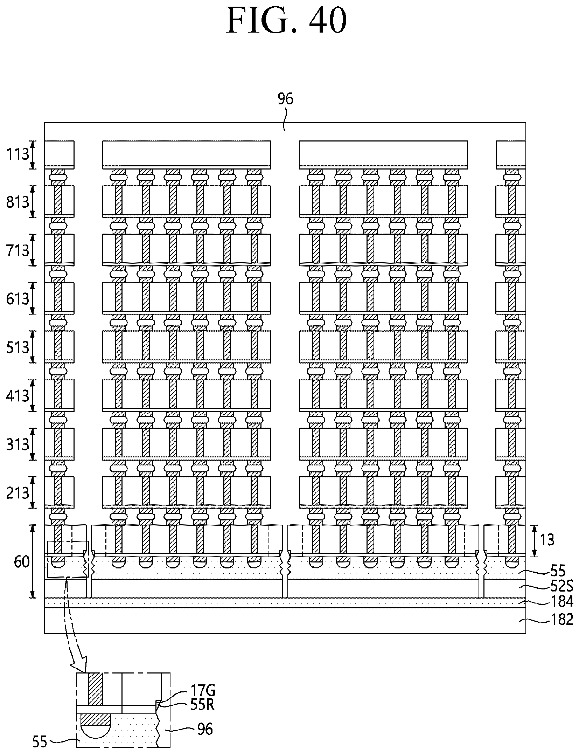

Referring to FIG. 37 and FIG. 40, an encapsulation layer 96 is formed B963 to cover the carrier chip 60, the plurality of core chips 213, 313, 413, 513, 613, 713, and 813, and the top chip 113. The encapsulation layer 96 covers the residual adhesive layer 55R and fills the groove 17G. The residual adhesive layer 55R may be trapped between the base chip 13 and the encapsulation layer 96.

The encapsulation layer 96 is partially removed to expose one surface of the top chip 113. The second carrier 182 and the second buffer layer 184 are removed.

As described with reference to FIG. 30, FIG. 31, and FIG. 36, the adhesive layer 55 and the silicon layer 52S are removed B970, and the encapsulation layer 96 is diced B982 to separate the semiconductor packages.

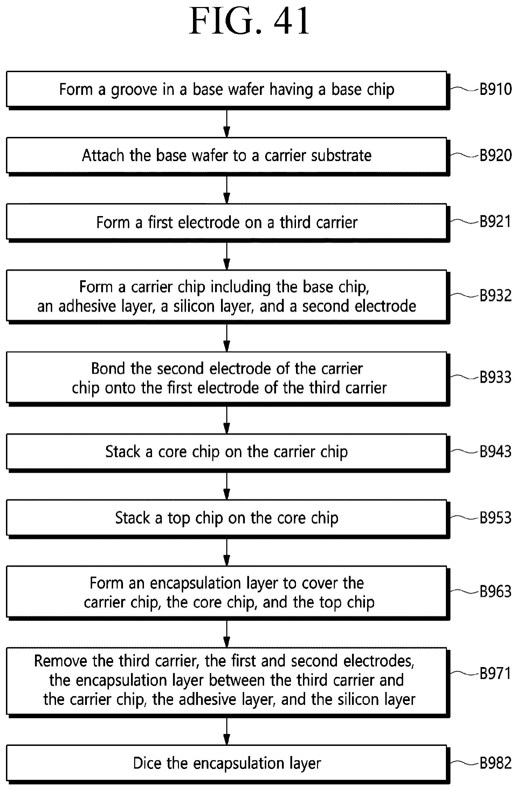

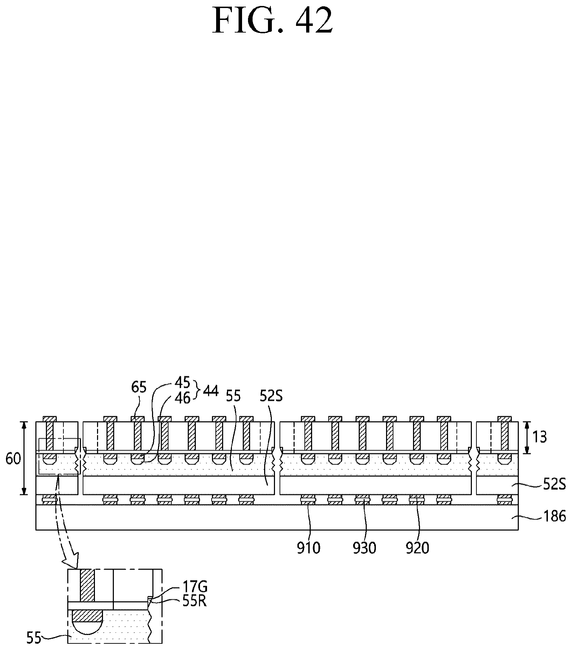

FIG. 41 is a flowchart illustrating a method of forming a semiconductor package according to an embodiment of the present disclosure. FIG. 42 to FIG. 44 are cross-sectional views of the semiconductor package formed utilizing the method according to an embodiment of the present disclosure.

Referring to FIG. 41, a method of forming a semiconductor package according to an embodiment of the present disclosure includes: forming B910 a groove in a base wafer having a base chip; attaching B920 the base wafer to a carrier substrate; forming B921 a first electrode on a third carrier; forming B932 a carrier chip including the base chip, an adhesive layer, a silicon layer, and a second electrode; bonding B933 the second electrode of the carrier chip to the first electrode of the third carrier; stacking B943 a core chip on the carrier chip; stacking B953 a top chip on the core chip; forming B963 an encapsulation layer to cover the carrier chip, the core chip, and the top chip; removing B971 the third carrier, the first and second electrodes, an encapsulation layer between the third carrier and the carrier chip, the adhesive layer, and the silicon layer; and dicing B982 the encapsulation layer. The processes of the flowchart may be performed in a different order and may include fewer or additional processes than described and shown in FIG. 41. Differences from FIG. 11 to FIG. 36 are described.

Referring to FIG. 42, a first electrode 910 is formed on a third carrier 186. A second electrode 920 is formed below a silicon layer 52S of the carrier chip 60. The second electrode 920 is bonded to the first electrode 910 via a connection electrode 930. The carrier chips 60 are repeatedly arranged in rows and columns on the third carrier 186 at regular intervals. The carrier chip 60 includes the base chip 13, the adhesive layer 55, the silicon layer 52S, the groove 17G, and the residual adhesive layer 55R. The residual adhesive layer 55R partially fills the groove 17G.

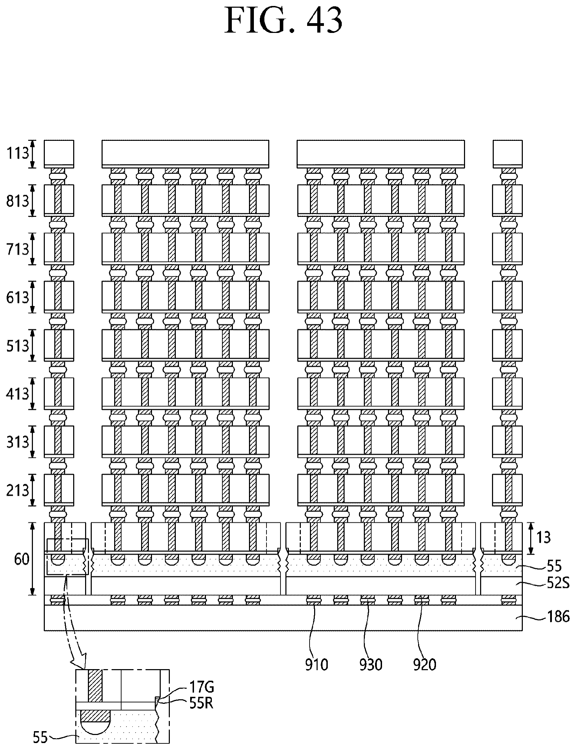

Referring to FIG. 41 and FIG. 43, a plurality of core chips 213, 313, 413, 513, 613, 713, and 813 are stacked B943 on the carrier chip 60. In an embodiment, the first core chip 213, the second core chip 313, the third core chip 413, the fourth core chip 513, the fifth core chip 613, the sixth core chip 713, and the seventh core chip 813 are sequentially stacked on the carrier chip 60. The seventh core chip 813 is the topmost core chip. A top chip 113 is stacked B953 on the seventh core chip 813.

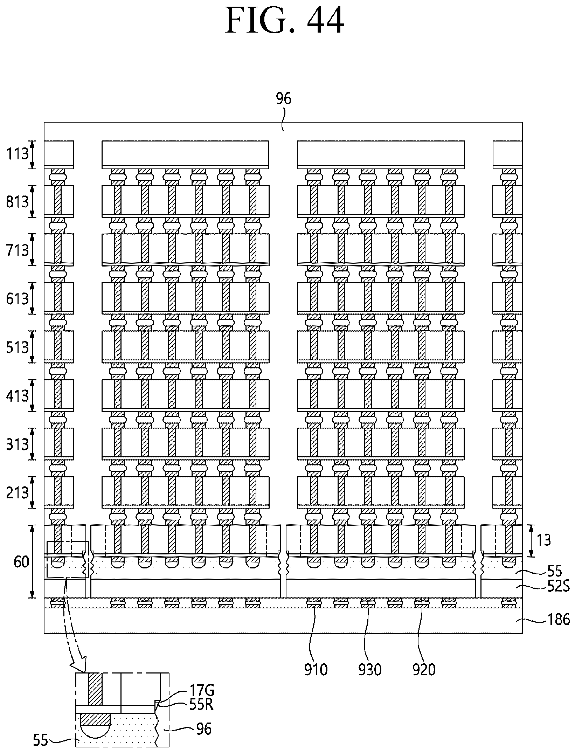

Referring to FIG. 41 and FIG. 44, an encapsulation layer 96 is formed B963 to cover the third carrier 186, the first electrode 910, the second electrode 920, the carrier chip 60, the plurality of core chips 213, 313, 413, 513, 613, 713, and 813, and the top chip 113. The encapsulation layer 96 covers the residual adhesive layer 55R and fills the groove 17G. The residual adhesive layer 55R may be trapped between the base chip 13 and the encapsulation layer 96.

Although not illustrated, the encapsulation layer 96 may be partially removed to expose one surface of the top chip 113. As described with reference to FIG. 30, FIG. 31, and FIG. 36, the third carrier 186, the first electrode 910, the second electrode 920, the encapsulation layer 96 between the third carrier 186 and the carrier chip 60, the adhesive layer 55, and the silicon layer 52S are removed B970, and the encapsulation layer 96 is diced B982 to separate the semiconductor packages.

Although the detailed embodiments are disclosed in the present disclosure, those skilled in the art will understand that various modifications, additions, and substitutions related to these embodiments are possible without departing from the scope and technical concepts of the present disclosure. Therefore, the scope of the present disclosure should not be limited to the foregoing embodiments. All changes within the meaning and range of equivalency of the claims are included within their scope.

## Claims

1. A semiconductor package comprising:
a base chip having a groove formed at an edge;
a residual adhesive layer in the groove;
a core chip on the base chip;
a top chip on the core chip; and
an encapsulation layer disposed between the base chip and the top chip, covering the core chip and the residual adhesive layer, and filling the groove.

2. The semiconductor package of claim 1,
wherein the encapsulation layer extends over a side surface of the base chip; and
wherein the residual adhesive layer is disposed between the base chip and the encapsulation layer.

3. The semiconductor package of claim 1,
wherein a width of the top chip in a first direction is larger than a width of the base chip in the first direction;
wherein the encapsulation layer extends over a side surface of the base chip; and
wherein a side surface of the encapsulation layer is substantially coplanar with a side surface of the top chip.

4. The semiconductor package of claim 1,
wherein the top chip has substantially the same width as a width of the core chip;
wherein the base chip has a larger width than a width of the top chip;
wherein the encapsulation layer extends over a side surface of the top chip; and
wherein the encapsulation layer extends over a side surface of the base chip.

5. The semiconductor package of claim 1, wherein the adhesive layer comprises polyolefin, polydimethylsiloxane, siloxane-phenyl copolymer, or a combination thereof.

6. The semiconductor package of claim 1, wherein the encapsulation layer comprises an epoxy molding compound.

7. The semiconductor package of claim 1, further comprising:
a base second electrode on the base chip;
a core first electrode between the base second electrode and the core chip;
a core second electrode on the core chip; and
a top first electrode between the core second electrode and the top chip, and
wherein the core chip comprises:
a core substrate; and
a core through-electrode passing through the core substrate and connected to the core first electrode and the core second electrode.

8. The semiconductor package of claim 1, wherein the encapsulation layer extends between the base chip and the core chip and between the core chip and the top chip.

9. The semiconductor package of claim 1, further comprising an intermediate encapsulation layer between the base chip and the core chip, wherein the intermediate encapsulation layer comprises a nonconductive film (NCF), underfill, or a combination thereof.

10. A semiconductor package comprising:
a base chip having a groove formed at an edge;
a core chip on the base chip;
a top chip on the core chip;
an encapsulation layer disposed between the base chip and the top chip and covering the core chip; and
a residual adhesive layer and a residual encapsulation layer in the groove.

11. The semiconductor package of claim 10,
wherein a width of the top chip in a first direction is substantially the same as a width of the base chip in the first direction; and
wherein a side surface of the base chip, a side surface of the encapsulation layer, and a side surface of the top chip are substantially coplanar.

12. The semiconductor package of claim 10,
wherein a width of the top chip in a first direction is substantially the same as a width of the core chip in the first direction;
wherein a width of the base chip in the first direction is larger than a width of the top chip in the first direction;
wherein the encapsulation layer extends over a side surface of the top chip; and wherein a side surface of the encapsulation layer is substantially coplanar with a side surface of the base chip.

13. The semiconductor package of claim 10, wherein the residual adhesive layer is disposed between the base chip and the residual encapsulation layer.
